Europäisches Patentamt

**European Patent Office**

**Office européen des brevets**

(19)

(11) Publication number: **0 025 665**
A1

## (12) EUROPEAN PATENT APPLICATION

(21) Application number: **80303060.0**

(22) Date of filing: **03.09.80**

(51) Int. Cl.³: **F 24 F 3/00,** F 24 F 7/10,
F 24 F 11/06

(30) Priority: **07.09.79 JP 115003/79**

(43) Date of publication of application: **25.03.81**
**Bulletin 81/12**

(84) Designated Contracting States: **AT BE CH DE FR GB IT**
**LI LU NL SE**

(71) Applicant: **FUJITSU LIMITED, 1015, Kamikodanaka**
**Nakahara-ku, Kawasaki-shi Kanagawa 211 (JP)**
Applicant: **FUJI KADEN CO., LTD., 13-11, Osaki 1-chome**
**Shinagawa-ku, Tokyo, 141 (JP)**

(72) Inventor: **Kobayashi, Kyoji, 2209-243, Fuchinobe,**
**Sagamihara-shi Kanagawa, 229 (JP)**
Inventor: **Kosaka, Takaichi, 850-22-403, Misawa**
**Hino-shi, Tokyo, 191 (JP)**
Inventor: **Takahara, Sigeki, 2-8-9-102, Miyamaedaira**
**Takatsu-ku, Kawasaki-shi Kanagawa, 213 (JP)**
Inventor: **Tamura, Akira, 29-2-405, Mitsuwadai 5-chome,**
**Chiba-shi Chiba, 280 (JP)**

(74) Representative: **Overbury, Richard Douglas et al,**
**HASELTINE LAKE & CO Hazlitt House 28 Southampton**
**Buildings Chancery Lane, London WC2A 1AT (GB)**

(54) **A cooling system.**

(57) Air conditioning apparatus (3) has a compressor (6), a condensor (7), an evaporator (8), an expansion valve (9), a blower (10) and a pump (11).

Cooling water from outdoor cooling tower 4 is passed to the condensor (7). Air circulating in computer room (1) passes evaporator (8) of the air conditioning apparatus (3) to be cooled.

A cold water switching valve (12) is provided for diverting cooling water supplied by tower (4) from condensor (7) to a cold water coil (13).

When the outside temperature is low enough to give sufficiently cold cooling water, valve (12) is operated to divert cooling water from the condensor (7) to the cold water coil (13), the compressor (6) is switched off and air circulating in the computer room (1) is cooled by cold water coil (13), instead of evaporator (8).

-1-

# A COOLING SYSTEM

This invention relates to a cooling system.

Recent data processing systems such as computers have a large heat generation density, due to the heat generated from a large number of semiconductor elements of a much improved operation rate and of a higher accommodation density. Whilst the heat generation density of an ordinary working office is 10 to 30 $kcal/hm^2$, that of a computer room is usually as high as 100 to 150 $kcal/hm^2$. In some cases, the heat generation density can reach 500 $kcal/hm^2$, depending on system layout.

Even in winter, when the outdoor temperature is low, the amount of heat leaked through the building to the outside is as little as only 1/5th to 1/10th of that generated from computer equipment and therefore the computer room is always cooled by a cooling system, even in the mid-winter, to a specified room temperature. Moreover, re-heating which works in opposition to surplus cooling capability is actually effected by means of an electric heater in order to make temperature regulation smooth. For this reason, it is completely unreasonable from the point of view of energy saving to conduct air cooling in the room in mid-winter.

According to the present invention there is provided a cooling system having outdoor cooling means and an indoor cold water coil, and means for circulating cooling water from the outdoor cooling means to the cold water coil for cooling air passing the cold water coil.

An embodiment of the present invention provides an economical cooling system using outdoor air and cold water, which rules out unreasonable use of energy for cooling as previously employed, and uses cold outdoor air in place of such cooling.

An embodiment of the invention uses outdoor air and cold water and is just suitable for cooling a system which generates a large amount of heat such as an electronic computer (hereinafter referred to as a computer) or a room in which such a computer is installed, and can realize energy savings through effective use of cold outdoor air.

Reference will be made, by way of example, to the accompanying drawings, in which:-

Figure 1 is a schematic block diagram of an embodiment of the present invention; and

Figures 2 to 5 are respective schematic block diagrams illustrating main parts of respective further embodiments of the present invention.

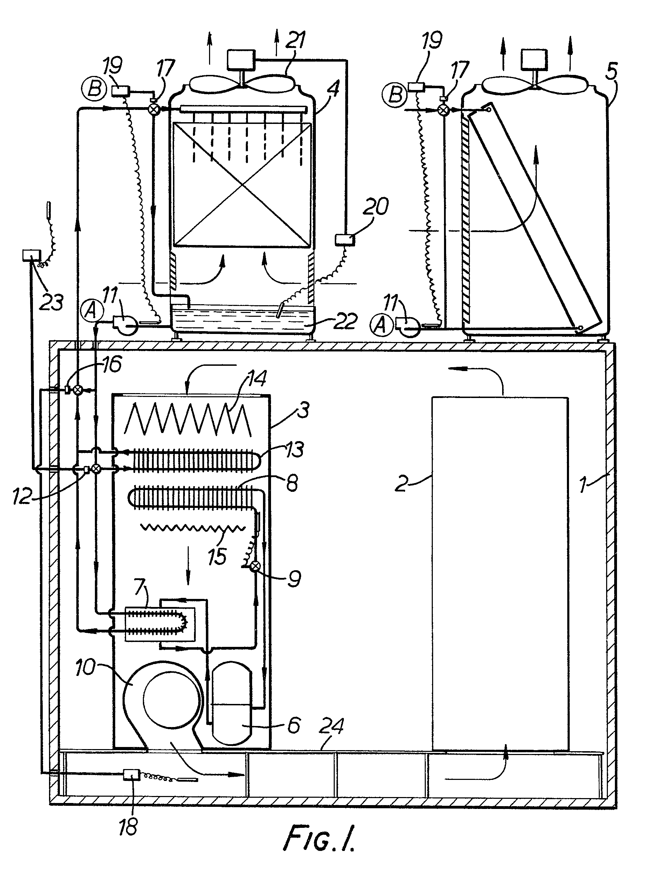

In Figure 1, 1 denotes a computer room; 2 is a computer; 3 is air conditioning apparatus; 4 is an outdoor cooling tower; 5 is a water cooling coil; 6 is a compressor; 7 is a condensor; 8 is an evaporator; 9 is an expansion valve (or capillary tube); 10 is a blower; and 11 is a pump.

Parts 1 to 11 are similar to those used in existing cooling systems.

In this embodiment of the present invention, however, a cold water switching valve 12 and a cold water coil 13 are additionally provided. When the outdoor air is cold, the compressor 6 ceases operation and cold water supplied from cooling tower 4 is sent to the cold water coil 13 in place of the condensor 7 through the cold water switching valve 12.

14 is an air filter and 15 is a re-heating electric heater.

Operations of the embodiment of Fig. 1 will be explained in detail.

First, when outdoor air temperature is not sufficiently low, an ordinary cooling operation is performed. Namely, the refrigerant (freon gas etc.) compressed by the compressor 6 is cooled and liquefied by the condensor 7. The liquefied refrigerant is subjected to pressure reduction in the expansion valve (or capillary tube) 9 and enters the evaporator 8. The air in the room which is circulated by the blower 10 through the air filter 14 is cooled by the heat of evaporization of the refrigerant as it passes the aforementioned evaporator 8. The refrigerant evaporated in the evaporator 8 enters the compressor 6 and is then compressed again, and the abovementioned operations are repeated.

On the other hand, in the cooling tower 4, coolant water which is caused to fall in the form of a shower is cooled by cold air and also by its own heat of evaporation (the latent heat) and circulates in the condensor 7 by means of the pump 11.

When outdoor air temperature is sufficiently low (the conditions will be explained later), the cold water which has been supplied to the condensor 7 is supplied to cold water coil 13 and compressor 6 ceases operation. Thereby, the room is directly cooled by the cold water coil 13. As a result, the power which is required for driving the compressor 6 and the re-heating heater 15 can be saved, realizing very efficient cooling by the cold water.

In a case in which water cooling coil 5 is used in place of cooling tower 4, the same operation as that mentioned above is performed by cooling the water through exchange of heat with the outdoor air.

Figure 1 shows water cooling coil 5 and cooling tower 4 but it will be appreciated that either 4 or 5 can be used as alternative means of water cooling.

When the cooling tower is used, the wet bulb temperature of outdoor air must be lower than the room temperature of the room to be cooled by 10 to $16^{\circ}$C for cooling using the cold water directly. When the water cooling coil is used, the dry bulb temperature of outdoor air must be lower than the room temperature by 10 to 16$^{o}$C.

A temperature regulation mechanism used in connection with cooling by outdoor air in accordance with this invention will now be explained.

In Fig. 1, 16 and 17 are three-way valves for bypass; 18, 19 and 20 are temperature detectors; 21 is a cooling tower blower. If the computer room 1 is cooled excessively and the air temperature of air blown out from the air conditioning apparatus 3 is reduced excessively, the three-way valve 16 bypasses the cold water by means of the signal of the temperature detector 18. Thus, the amount of cold water to be sent to the cold water coil 13 is adjusted, thereby maintaining the temperature of air blown from the air conditioning apparatus at the specified value. In order to prevent excessive cooling of the cold water, the temperature of cold water in the cooling tower 4 is detected by a temperature detector 20 and if the water is excessively cooled, the blower 21 is caused to cease operation. Otherwise, the three-way valve 17 may be adjusted with a signal sent from the temperature detector 19 and thereby the cold water may be bypassed to the water tank 22 of the cooling tower. When a water cooling coil is used, temperature regulation can be effected in a similar manner.

Switching of the switching valve 12 can be effected automatically by means of a regulator 23 in accordance with the condition of the outdoor air, i.e. the temperature and the humidity.

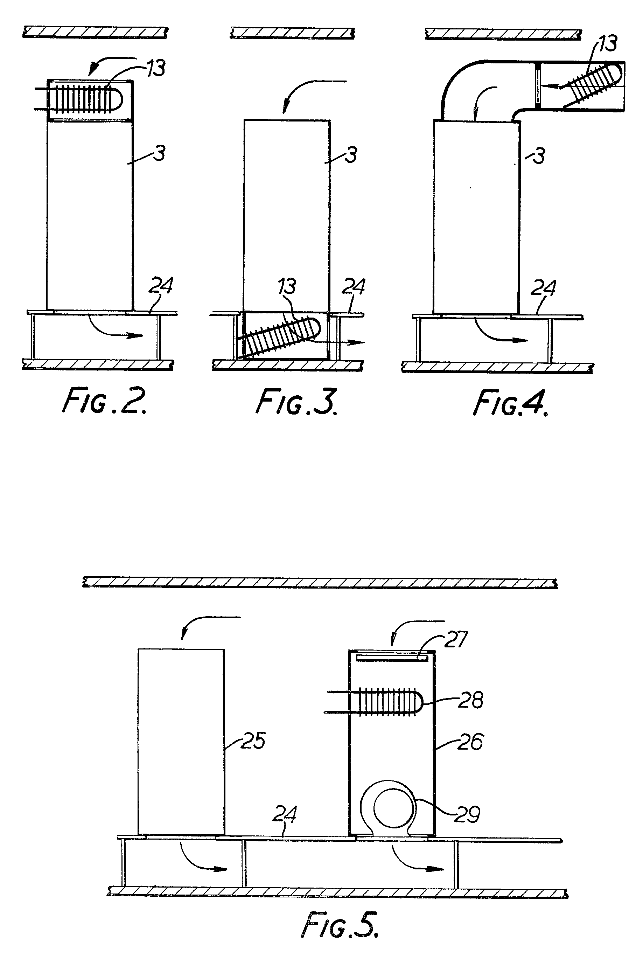

As explained above, an embodiment of the present invention has great merit from the point of view of energy saving because it does not generally require the compressor 6 and re-heating heater 15 to be used in the winter season, and effects cooling directly with cold water. The cold water coil 13 can be built in the air conditioning apparatus as shown in Fig. 1 and also it can be mounted as an attachment at a suction port or discharge port of existing air conditioning apparatus

0025665

as indicated in Fig. 2 to Fig. 4. Alternatively, as shown in Fig. 5, a blower 29 can be built in a locker 26, with a cold water coil 28 and used together with an existing cooling system 25       perfectly independent ..                    of the existing cooling system.  27 is an air filter and 24 is a free access floor.

Thus, the present invention provides a cooling system which utilizes cold outdoor air and water, for cooling equipment such as a computer which generates large amounts of heat.  An embodiment of the invention has a cold water coil and a cold water switching valve in addition to an ordinary air conditioning apparatus, and when the outdoor temperature is sufficiently low, cooling water is switched to the cold water coil from a condensor of the ordinary apparatus, and air in the computer room is cooled directly by the cold water.

CLAIMS.

1.   A cooling system, comprising air conditioning apparatus having a condensor, and outdoor cooling means for providing cooling water for circulation to the condensor, characterized in that the system further comprises a water switching valve disposed in the path of circulation of cooling water from the outdoor cooling means to the condensor, and a cold water coil connected to the said path of circulation by way of the water switching valve, the water switching valve being operable so that cooling water can be diverted from the condensor to the cold water coil.

2.   A system as claimed in claim 1, wherein the water switching valve is operable selectively to pass the cooling water to the condensor or to the cold water coil in dependence upon outdoor air temperature.

3.   A system as claimed in claim 1 or 2, further comprising a temperature sensor disposed for sensing the temperature of air cooled by the air conditioning apparatus or by the cold water cooling coil, and a bypass valve, disposed in the said path of circulation, operable to control the amount of cooling water passing from the outdoor cooling means to the cold water coil (when the water switching valve is diverting cooling water to the cold water coil) in dependence upon the temperature sensed by the temperature sensor.

4.   A system as claimed in claim 1, 2 or 3, further comprising a cooling water temperature sensor disposed for sensing the temperature of cooling water as delivered from the outdoor cooling means, and a valve disposed in the said path of circulation and operable, in dependence upon the temperature as sensed by the cooling water temperature sensor, to divert cooling water, on its return to the outdoor cooling means, from a normal input end of the outdoor cooling means to a cooling water output of the outdoor cooling means, so that the returned cooling water is not cooled in the outdoor cooling means.

5.    A system as claimed in any preceding claim, further comprising a cooling water temperature sensor, disposed for sensing the temperature of cooling water as delivered from the outdoor cooling means, and wherein the outdoor cooling means comprises an air blower operable to assist water cooling therein, the air blower being brought into operation in dependence upon the temperature sensed by the cooling water temperature sensor.

6.    A system as claimed in any preceding claim, wherein the air conditioning apparatus comprises, in addition to the condensor, a compressor, an expansion valve or a capillary tube, an evaporator and a blower.

7.    A system as claimed in any preceding claim, wherein the outdoor cooling means comprises an outdoor cooling tower.

8.    A system as claimed in any preceding claim, wherein the outdoor cooling means comprises an outdoor cooling coil.

9.    A system as claimed in any preceding claim, wherein the air conditioning apparatus and the cold water coil are in a computer room.

FIG. 1.

0025665

FIG.2.

FIG.3.

FIG.4.

FIG.5.

European Patent Office

**EUROPEAN SEARCH REPORT**

0025665

Application number

EP 80 30 3060.0

| Category | Citation of document with indication, where appropriate, of relevant passages | Relevant to claim |
|---|---|---|
| P,A | EP - A1 - 0 007 396 (SIEMENS AG)<br>* complete document *<br>-- | |
| A | DD - A - 86 247 (FISCHER et al.)<br>* complete document *<br>-- | |
| A | US - A - 3 850 007 (McFARLAN)<br>* complete document *<br>---- | |

**CLASSIFICATION OF THE APPLICATION (Int. Cl.3)**

F 24 F   3/00
F 24 F   7/10
F 24 F  11/06

**TECHNICAL FIELDS SEARCHED (Int.Cl.3)**

F 24 F    3/00
F 24 F    7/00
F 24 F   11/00

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

X The present search report has been drawn up for all claims

| Place of search | Date of completion of the search | Examiner |
|---|---|---|
| Berlin | 04-12-1980 | PIEPER |

EPO Form 1503.1   06.78